# EUROPÄISCHE PATENTSCHRIFT

(11) **EP 0 463 523 B1**
(45) Veröffentlichungstag und Bekanntmachung des Hinweises auf die Patenterteilung: **13.11.1996**
(21) Anmeldenummer: 91109847.3
(22) Anmeldetag: 15.06.1991
(51) Int. Cl.: H03K 17/08, H03K 17/0814

(54) **Leistungs-Halbleiterschaltung**
Power semiconductor circuit
Circuit semi-conducteur de puissance

(30) Priorität: 25.06.1990 CH 2106/90
(43) Veröffentlichungstag der Anmeldung: 02.01.1992
(73) Patentinhaber: ASEA BROWN BOVERI AG, CH-5401 Baden (CH)
(72) Erfinder: Grüning, Horst, Dr., CH-5404 Baden (CH); de Lambilly, Hervé. Dr., CH-5415 Nussbaumen (CH); Steinruck, Ferdinand, CH-6295 Mosen (CH)

(56) Entgegenhaltungen:
- EP-A- 0 185 181
- EP-A- 0 268 260
- DE-A- 3 737 906
- US-A- 4 876 635
- RGE, Nr. 2, Februar 1986, Seiten 19-22; G. MOURIES: "Evolution des condensateurs de puissance secs"

## Beschreibung

### Technisches Gebiet

Die Erfindung betrifft eine Leistungs-Halbleiterschaltung, umfassend ein über ein Gate abschaltbares Halbleiterbauelement und eine Diode.

### Stand der Technik

Die neuen, schnellen, über ein Gate abschaltbaren Leistungs-Halbleiterbauelemente, die in der Leistungselektronik zunehmend Verwendung finden, wie z.B. der FCTh (Field Controlled Thyristor), der IGBT (Insulated Gate Bipolar Transistor), der MCT (MOS Controlled Thyristor) oder der HF-GTO erfordern zur Ansteuerung kurze Stromimpulse mit sehr hohen Stromanstiegsgeschwindigkeiten di/dt.

Um solche hohen di/dt-Werte erreichen zu können, sind für die Induktivität L des Ansteuerkreises Gesamtwerte von nur einigen nH oder unter Umständen von < 1 nH erlaubt. Eine Anordnung des Ansteuerkreises ausserhalb des Bauelement-Gehäuses und eine Zuleitung der Steuerpulse z.B. durch Koaxialkabel ist damit nicht mehr möglich.

Eine Lösung dieses Problems geht aus der Schweizer Patentanmeldung CH-408/89-1 hervor. Es handelt sich dabei um eine schnelle Leistungs-Halbleiterschaltung der eingangs genannten Art. Der wesentliche Teil dieser älteren Anmeldung betrifft einen flexiblen Bandleiter als niederinduktive Verbindung zwischen Halbleiterbauelement und Ansteuerkreis.

Die in neuerer Zeit entwickelten einrastenden, feinstrukturierten, bipolaren Halbleiterbauelemente, wie z.B. FCTh, FSGTO (Fein Strukturierter GTO) oder SITh, zeigen bei sehr schneller Ansteuerung (Anstiegszeit des Gatestroms < 200 ns) stark verbesserte Abschalteigenschaften. Sie erlauben dann die schnelle Verarbeitung hoher Ströme und Spannungen (dVₐ/dt ≥ 10 kV/µs, I > 100 A, U ≥ 2 kV). Voluminöse und aufwendige Snubberbeschaltungen, wie sie derzeit bei GTOs unumgänglich sind, können dabei in der Regel ganz entfallen. Voraussetzung ist jedoch, dass das "Reverse Recovery" der Freilaufdioden keine übermässigen Spannungsspitzen an parasitären Induktivitäten hervorrufen kann.

Bei den auf kleiner Spannungen (< 1 kV) beschränkten IGBTs führen Reverse Recovery der Freilaufdioden und Kommutationsspannungsspitzen zu Problemen, wenn grössere Ströme (> 100 A) geschaltet werden sollen. Um diese zu vermeiden müssen demzufolge entweder wieder Snubbers eingesetzt werden oder Widerstände im Eingangskreis zur Verlangsamung der Ansteuergeschwindigkeit (siehe z.B. "Switching Performance of a new fast IGBT", L. Lorenz, G. Schulze, PCI - Juni 1988 Proceedings, pp 189-202). In ähnlicher Weise leiden auch schnelle fein strukturierte Bipolartransistoren (z.B. SIRET = SIEMENS Ring Emitter Transistor) im Ausschaltvorgang unter Ueberspannungsspitzen. Infolgedessen sind sie in der Praxis gar nicht mit der vollen Schaltgeschwindigkeit anwendbar.

Der Artikel RGE, Nr. 2, Februar 1986, Seiten 19-22 ; G.MOURIES : "Evolution des condensateurs de puissance secs" beschreibt (vgl. Figur 7) eine Leistungs-Halbleiterschaltung, wobei Diode und Kondensator räumlich unmittelbar neben dem Halbleiterbauelement angeordnet sind.

### Darstellung der Erfindung

Aufgabe der Erfindung ist es nun, eine anwenderfreundliche Leistungs-Halbleiterschaltung der eingangs genannten Art anzugeben.

Insbesondere ist es auch Aufgabe der Erfindung, ein niederinduktives, mit mindestens einem FCTh oder einem FSGTO arbeitendes Halbbrückenmodul anzugeben, welches hohe Ströme verarbeiten kann, kompakt ist, und für den Anwender einfach und modular einsetzbar ist.

Erfindungsgemäss besteht die Lösung darin, dass
c) die Diode in Serie zum Halbleiterbauelement angeordnet ist, derart dass Diode und Halbleiterbauelement einen Viertelbrückenzweig bilden,
d) parallel zur Serieschaltung von Halbleiterbauelement und Diode ein niederinduktiver Abblockkondensator zum Auffangen der Reverse Recovery Spannungsspitzen der Diode vorgesehen ist, und
f) Diode und Abblockkondensator niederinduktiv und räumlich unmittelbar neben dem Halbleiterbauelement angeordnet sind.

Der springende Punkt bei der Erfindung liegt in der Gestaltung des Ausgangskreises. Sie erlaubt es, ein anwenderfreundliches Modul aufzubauen. Durch die niederinduktive Anordnung werden nämlich Spannungsspitzen auf ein Minimum reduziert bei gleichzeitig maximaler Ansteuergeschwindigkeit. Kurzschlussprobleme werden vermieden, da beim Schalten innerhalb der Anordnung nicht irgendwelche unerwünschte (fatale) Kondensatorentladungsströme über das Halbleiterbauelement fliessen können. Ein allfälliger Kurzschluss kann somit von aussen detektiert werden, so dass ohne Schaden abgestellt werden kann.

Ein wichtiger Aspekt der Erfindung stellt die Aufteilung der bei der Beschaltung des Halbleiterbauelements benötigten Kapazität auf einen internen, nicht allzu grossen, niederinduktiven Abblockkondensator und einen externen Kondensator dar. Der Abblockkondensator, der wegen seiner relativ bescheidenen Grösse sehr nahe beim Leistungsschalter angeordnet sein kann und mit diesem somit niederinduktiv verbunden werden kann, kann die starken Spannungsspitzen optimal aufnehmen. Wichtig ist dabei, dass für den Aufbau z.B. einer Brückenschaltung, die drei Elemente Leistungsschalter, Diode und Abblockkondensator in unmittelbarer räumlicher Nachbarschaft zu einem Viertelbrückenzweig zusammengefasst werden.

Für die Realisierung der erfindungsgemässen Leistungs-Halbleiterschaltung ist es im Hinblick auf die gewünschte niedrige Induktivität besonders vorteilhaft, wenn der Abblockkondensator ein niederinduktiver flacher Keramikchip ist, welcher auf oder neben der als flacher Halbleiterchip ausgebildeten Diode angeordnet ist.

Damit der Abblockkondensator möglichst klein gehalten werden kann bei gleichzeitig guter Abblockwirkung, empfiehlt es sich die Kapazität des Abblockkondensators so zu bemessen, dass eine Reverse Recovery Ladung der Diode nur zu einer Spannungsänderung delta_{_}U_{C} führen kann, die nicht mehr als 20 % einer Versorgungsgleichspannung U_{DC} beträgt.

Zur Realisierung eines handlichen und anwenderfreundlichen elektrischen Bauteils sind folgende konstruktive Massnahmen vorzusehen:
a) Halbleiterbauelement, Diode, Abblockkondensator und Bandleiter sind als Viertelbrückenzweig in einem Modulgehäuse untergebracht,
b) zur Zuführung der Versorgungsgleichspannung U_{DC} sind zumindest zwei breite, niederinduktive Metallaschen als Plus- resp. Minus-Zuführung vorgesehen und
c) ein nach aussen führender Lastanschluss ist zwischen Diode und Halbleiterbauelement angeschlossen.

Besonders vorteilhaft ist es,
a) in einem Modulgehäuse im Sinn eines Halbbrückenmoduls mindestens zwei Viertelbrückenzweige unterzubringen, wobei
b) im einen Viertelbrückenzweig im Sinn eines HS-Zweiges das Halbleiterbauelement mit der Anode an die Plus-Zuführung und die Diode zwischen Kathode und Minus-Zuführung geschlossen ist, und im zweiten im Sinn eines LS-Zweiges das Halbleiterbauelement mit der Kathode an die Minus-Zuführung und die Diode zwischen Anode und Plus-Zuführung geschlossen ist, und wobei
c) zum Vermindern der Stromanstiegsgeschwindigkeit im Fall des Durchzündens die Lastanschlüsse der Viertelbrückenzweige über eine Induktivität verbunden sind.

In der Praxis gehören nämlich Brückenschaltungen zu den verbreitetsten Anwendungen für Leistungs-Halbleiterschaltungen.

Vorzugsweise wird die Induktivität so realisiert, dass die Lastanschlüsse der beiden Zweige separat aus dem Modulgehäuse herausgeführt sind und dort je nach Anwendungsfall einfach kurzgeschlossen oder durch eine weitere Drossel verbunden werden.

Zum Dämpfen der Spannungsspitzen kann entweder zwischen Plus- und Minuszuführung zusätzlich ein separater Clamping-Kondensator vorgesehen sein oder die Zuführungen zwischen HS- und LS-Zweig können niederinduktiv ausgeführt sein, wobei die Zuführungen ausserhalb der HS- und LS-Zweige Zwecks Dämpfung von Spannungsspitzen z.B. mit einem RC-Dämpfungsnetzwerk beschaltet werden.

Wenn das Halbleiterbauelement einerseits und Diode und Abblockkondensator andererseits auf einem isolierenden Keramiksubstrat unmittelbar nebeneinander angeordnet sind, dann gestaltet sich die Kühlung des Halbleiterbauelements einfach. Sowohl Leistungs-Schalter als auch Diode können vom Keramiksubstrat her effizient gekühlt werden. Wenn alle drei (chipförmigen) Bauelemente aufeinander gestapelt werden, lässt sich eventuell eine besonders niedere Induktivität realisieren, aber Diode resp. Abblockkondensator werden dann durch die unvermeidlichen Schaltverluste im Halbleiterbauelement unnötigerweise erhitzt.

Um zu verhindern, dass die Spannungsfestigkeit, die der Leistungsschalter als solcher aufweist, im eingebauten Zustand nicht vermindert ist, weist der Bandleiter einen auf eine Hauptfläche des Halbleiterbauelements aufgelöteten Abschnitt auf und ist unmittelbar ausserhalb des aufgelöteten Abschnitts derart von der Hauptfläche weggekrümmt, dass ein sich im Sperrzustand des Halbleiterbauelements aufbauendes elektrisches Feld am Rand der Hauptfläche nicht gestört wird.

In der Praxis haben sich folgende Spezifikationen und Dimensionierungen bewährt:
a) Als abschaltbares Halbleiterbauelement wird ein FCTh resp. ein komplementärer FCTh eingesetzt, welcher in der Art eines Cu-Direct-Bondings auf dem Keramiksubstrat fixiert ist;
b) Der Abblockkondensator hat eine Kapazität zwischen 50 und 200 nF;
c) Der zusätzliche Clamping-Kondensator hat eine Kapazität zwischen 1 und 5 µF;
d) Die Ansteuerschaltung umfasst mindestens einen MOSFET und mindestens einen Speicherkondensator, welche direkt auf den Bandleiter aufgelötet sind; und
e) Der Bandleiter ist flexibel.

Das abschaltbare Halbleiterbauelement kann auch ein IGBT sein. Gemäss der Erfindung wird dieser mit maximaler Geschwindigkeit angesteuert. Es ist also auch bei grossen Strömen nicht mehr nötig, Gate-Widerstände oder Snubberbeschaltungen einzusetzen, um die Betriebssicherheit gewährleisten zu können. Wie bereits vermerkt worden ist, ist nicht jeder IGBT strombegrenzend (insbesondere nicht bei hohen Strömen).

Aus der Gesamtheit der abhängigen Patentansprüchen ergeben sich weitere vorteilhafte Ausführungsformen.

### Kurze Beschreibung der Zeichnungen

Nachfolgend soll die Erfindung anhand von Ausführungsbeispielen und im Zusammenhang mit den Zeichnungen näher erläutert werden. Es zeigen:
- Fig. 1: eine Schaltanordnung für ein Halbbrückenmodul;
- Fig. 2a,b: eine konstruktive Ausführung eines HS-Moduls; und
- Fig. 3a,b: eine konstruktive Ausführung eines LS-Moduls.

Die in den Zeichnungen verwendeten Bezugszeichen und deren Bedeutung sind in der Bezeichnungsliste zusammenfassend aufgelistet. Grundsätzlich sind in den Figuren gleiche Teile mit gleichen Bezugszeichen versehen.

### Wege zur Ausführung der Erfindung

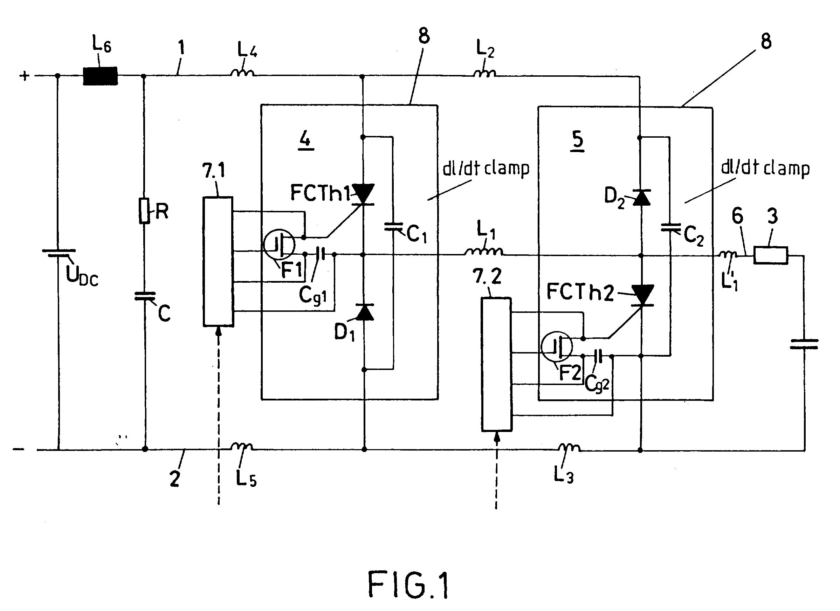

Fig. 1 zeigt eine Schaltanordnung für ein Halbbrückenmodul. Eine Plus-Zuführung 1 und eine Minus-Zuführung 2 bieten eine Versorgungsgleichspannung U_{DC} an, welche es mit einem Halbbrückenmodul in eine Wechselspannung zur Versorgung einer Last 3 umzuwandeln gilt.

Die Halbbrücke setzt sich zusammen aus zwei Viertelbrückenzweigen, nämlich einem HS-Zweig 4 (High Side) und einem LS-Zweig 5 (Low Side). Die beiden Viertelbrückenzweige umfassen im wesentlichen jeweils ein abschaltbares Halbleiterbauelement FCTh1 resp. FCTh2 mit einer Anode, einer Kathode und einem Gate, eine Diode D1 resp. D2 und einen Abblockkondensator C1 resp. C2. Zwischen Kathode und Gate befindet sich jeweils ein Ansteuerschaltung, mit welcher die Halbleiterbauelemente FCTh1, FCTh2 ein- und ausgeschaltet werden können.

Schaltungstechnisch ist der HS-Zweig 4 wie folgt aufgebaut. Zwischen Plus- und Minus-Zuführung 1 und 2 sind Halbleiterbauelement FCTh1 und Diode D1 in Serie geschaltet. Das Halbleiterbauelement FCTh1 ist also mit seiner Anode an die Plus-Zuführung und mit seiner Kathode an einen nach aussen führenden Lastanschluss 6 angeschlossen. Die Diode D1 ist mit ihrer Anode an die Minus-Zuführung 2 und mit ihrer Kathode ebenfalls an den genannten Lastanschluss 6 angehängt. Parallel zur Serieschaltung von Halbleiterbauelement FCTh1 und Diode D1 ist gemäss der Erfindung der Abblockkondensator C1 angeordnet.

Der LS-Zweig 5 ist ähnlich aufgebaut. Der wesentliche Unterschied zum HS-Zweig 4 liegt in der vertauschten Position von Halbleiterbauelement FCTh2 und Diode D2. Die beiden Elemente sind also je mit ihrer Anode am Lastanschluss 6 angeschlossen. Ausserdem hängt das abschaltbare Halbleiterbauelement FCTh2 mit seiner Kathode an der Minus-Zuführung 2.

Die Ansteuerschaltungen sind in an sich bekannter Art ausgeführt. Sie umfassen je eine Gate-Unit 7.1, 7.2, einen oder mehrere parallel geschaltete MOSFETs F1, F2 und für jeden MOSFET F1, F2 einen Kondensator Cg1, Cg2 für den Gatestrom.

Kernpunkt der Erfindung sind die kleinen Abblockkondensatoren C1, C2 mit extrem niedriger Eigeninduktivität zum Auffangen der Reverse Recovery Spannungsspitzen der entsprechenden Diode D1, D2. Sie sind vorzugsweise als Keramikchips ausgebildet und zusammen mit der jeweiligen Diode D1, D2 räumlich unmittelbar neben dem Halbleiterbauelement angeordnet. Die in diesem Kreis auftretende Induktivität sollte weit kleiner als 100 nH, vorzugsweise ≦ 10 nH sein.

Bevorzugterweise sind die Abblockkondensatoren C1, C2 kapazitätsmässig so ausgelegt, dass eine Reverse Recovery Ladung der zugehörigen Diode D1, D2 nur zu einer Spannungsänderung delta_U_{C} ≤ 0.2 U_{DC} (20% der Versorgungsgleichspannung) führen kann. In der Praxis haben sich Kapazitätswerte zwischen 50 und 200 nF bewährt.

Ein wichtiger Aspekt bei der erfindungsgemässen Halbbrückenschaltung ist die mit L1 bezeichnete Induktivität, welche im Lastanschluss 6 zwischen Halbleiterbauelement FCTh1 des HS-Zweiges 4 und demjenigen (FCTh2) des LS-Zweiges vorgesehen ist. Ihr fällt die Aufgabe zu, bei einem versehentlichen Durchzünden (beide Halbleiterbauelemente leitend) oder einem Lastkurzschluss die Stromanstiegsgeschwindigkeit zu beschränken.

Wenn HS- und LS-Zweig 4 resp. 5 entsprechend einer bevorzugten Ausführungsform im Sinn eines Halbbrückenmoduls in einem einzigen Modulgehäuse 8 untergebracht sind, dann kann die geforderte Induktivität L1 u.U. schon dadurch realisiert werden, dass die Lastanschlüsse der beiden Zweige separat aus dem Modulgehäuse herausgeführt sind und dort im Anwendungsfall einfach kurzgeschlossen werden.

Zwischen HS- und LS-Zweig 4 resp. 5 sollen Plus- und Minus-Zuführungen 1 und 2 möglichst niederinduktiv (vgl. Induktivitäten L2, L3, L4, L5) sein, damit beide Bauelementgruppen bei Spannungs- oder Stromstössen gleich stark belastet werden. Kommutierungsspannungsspitzen, die durch L6 hervorgerufen werden, können wirksam durch ein RC-Dämpfungsnetzwerk (R ≥ 0) gedämpft werden.

L6 symbolisiert die auf der Versorgungsseite vorhandenen Streuinduktivitäten. Zum Verringern störender Einflüsse derselben, können zusätzlich Dämpfungsmittel zugeschaltet werden. Gemäss einem ersten Vorschlag ist zwischen Plus- und Minus-Zuführung 1 und 2 zusätzlich ein grösserer separater Clamping-Kondensator C vorgesehen. Dessen Kapazität beträgt vorzugsweise 1 - 5 µF. Anstelle des Clamping-Kondensators können auch dämpfende Induktivitäten L4, L5 in die Versorgungsspannungsanschlüsse (Plus- und Minus-Zuführung) eingebaut werden. Die Dimensionierung dieser Dämpfungsmittel richtet sich in bekannter Weise nach der Streuinduktivität L6.

Ein weiterer wichtiger Aspekt der Erfindung besteht darin, das Halbleiterbauelement über einen niederinduktiven Bandleiter mit einer niederinduktiven Schaltung anzusteuern. Die Verwendung eines solchen Bandleiters ist bereits Gegenstand der älteren Patentanmeldung CH-408/89-1. Bei den nachfolgenden Erläuterungen werden daher die Einzelheiten des niederinduktiven Bandleiters sowie der Ansteuerung nicht erneut diskutiert.

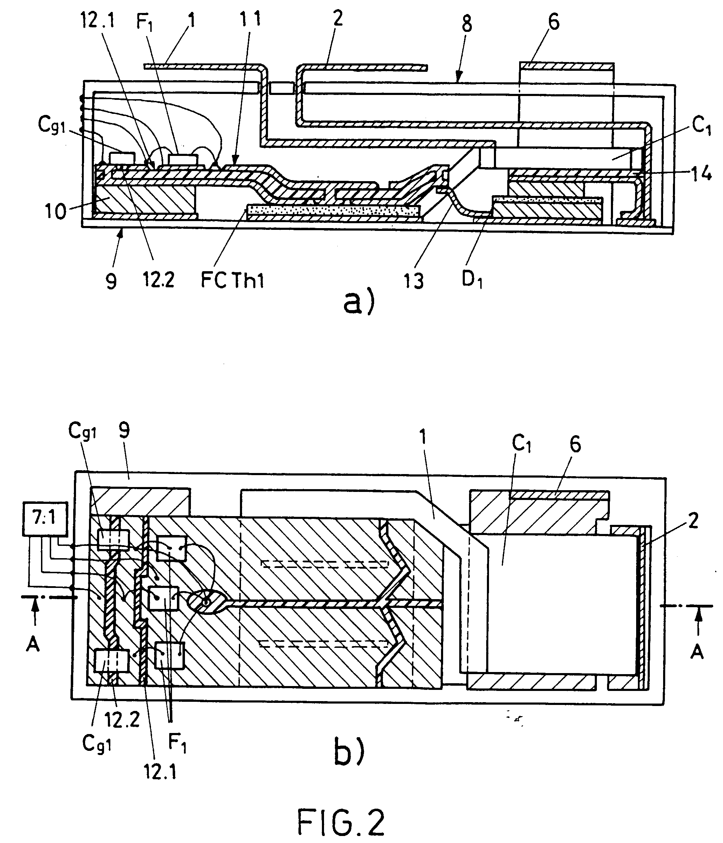

Fig. 2a, b zeigt einen bevorzugten konstruktiven Aufbau eines Viertelbrückenmoduls im Sinn eines HS-Zweiges. In der Fig. 2a ist dabei der Längsschnitt und in Fig. 2b die entsprechende Aufsicht gezeigt. Der Schnitt gemäss Fig. 2a erfolgte entlang Linie A-A.

In einem Modulgehäuse 8 sind auf einem Keramiksubstrat 9 nahe nebeneinander ein abschaltbares Halbleiterbauelement FCTh1, vorzugsweise ein Field-Controlled Thyristor (FCTh), eine Diode D1 und ein Abblockkondensator C1 angeordnet. Der FCTh ist mit seiner Anode z.B. im Sinn eines sog. direct copper Bondings auf dem Keramiksubstrat (z.B. Al₂O₃) aufgelötet, so dass eine gute Wärmeabfuhr ermöglicht wird.

Gemäss einer bevorzugten Ausführungsform der Erfindung ist der Abblockkondensator C1 ein niederinduktiver flacher Keramikchip, welcher auf der als flacher Halbleiterchip ausgebildeten Diode D1 angeordnet ist. Die beiden aufeinandergestapelten Bauelemente sind auf der einen Seite des Halbleiterbauelements FCTh1 auf das Keramiksubstrat aufgelötet. Die Diode D1 wendet ihre Kathode dem Keramiksubstrat 9 zu. Mit ihrer Anode ist sie an die Minus-Zuführung 2 geschlossen. Zwischen Kathodenseite der Diode D1 und darüberliegendem Abblockkondensator C1 (Keramikschip) ist eine Isolationschicht 14 eingeschoben. Ein erster Kontakt am Rand des Keramikchips ist ebenfalls an die Minus-Zuführung 2 angeschlossen.

Ein flexibler, kupferkaschierter Bandleiter 11 besorgt die niederinduktive Verbindung mit der Ansteuerschaltung. Er ist in einem mittleren Abschnitt mit seiner unteren Seite auf die Kathodenseite des Halbleiterbauelements FCTh1 aufgelötet. Dabei macht er einerseits mit der Kathode und andererseits mit dem Gate des Leistungsschalters Kontakt. Zu diesem Zweck ist seine Kupferschicht mit geeigneten Aetzgräben 12.1, 12.2 in voneinander isolierte Kontaktbereiche aufgeteilt (siehe Patentanmeldung CH-408/89-1.

Ein erstes freies Ende des Bandleiters 11 ist auf einen erhöhten Kontaktpfosten 13 und ein zweites gegenüberliegendes Ende auf einen Kupferblock 10, welcher eine erhöhte Sockelfläche schafft, aufgelötet. Der springende Punkt bei der erfindungsgemässen seitlichen Fixierung des Bandleiters 11 liegt darin, dass der Bandleiter 11 aufgrund seiner Flexibilität so geformt ist, dass seine untere Seite unmittelbar ausserhalb des auf das Halbleiterbauelement FCTh1 aufgelöteten Abschnitts von dessen Hauptfläche weggekrümmt ist. Damit ist das elektrische Feld, welches sich im sperrenden Zustand in der Nähe der Ränder des Bauelements aufbaut, im wesentlichen nicht gestört.

Die Ansteuerschaltung umfasst eine externe (in Fig. 2b gezeigte) Gate-Unit GU sowie (beispielsweise zwei) Kondensatoren Cg1 und (beispielsweise drei) MOSFETs F1. Die zuletzt genannten Schaltelemente sind vorzugsweise auf der oberen Seite des auf den Kupferblock 10 aufgelöteten Endes des Bandleiters 11 (wie in der Patentanmeldung CH-408/89-1 beschrieben) angeordnet.

Vorzugsweise sind Plus- und Minus-Zuführung 1 und 2 als breite, niederinduktive Metallaschen ausgebildet. Die geforderte niedrige Induktivität wird insbesondere auch dadurch erreicht, dass die Metallaschen über einen möglichst grossen Längenabschnitt hinweg (innerhalb des Modulgehäuses 8) in möglichst kleinem Abstand zueinander (je geringer der Abstand desto kleiner die Induktivität) parallel geführt sind.

Aus dem Modulgehäuse 8 ist ausserdem ein Lastanschluss 6 herausgeführt. Wenn gemäss einer bevorzugten Ausführungsform in einem gemeinsamen Modulgehäuse sowohl ein HS- als auch ein LS-Zweig untergebracht sind, dann können zwei Lastanschlüsse vorgesehen sein. Um die oben beschriebene Induktivität L1 zu realisieren, können werden die Metallaschen der Lastanschlüsse so geformt sein, dass sie zusammen mit einem extern angebrachten Kurzschluss gerade die geforderte Induktivität aufweisen.

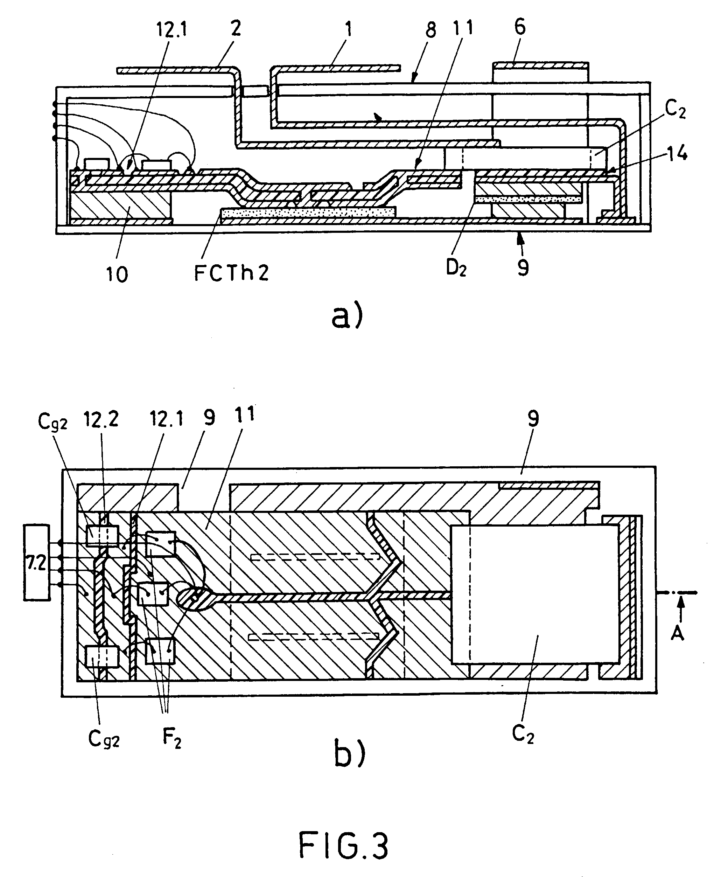

Fig. 3a,b zeigt ein LS-Modul. Im wesentlichen hat es die selben Merkmale wie das soeben beschriebene HS-Modul. Unterschiedlich sind die Polung der Diode D2 und die Versorgungsspannungsanschlüsse. Im vorliegenden Fall wendet die Diode D2 ihre Anodenseite dem Keramiksubstrat 9 zu. Der Bandleiter 11 ist unmittelbar am Keramikchip (Abblockkondensator C1) angelötet. Da der Keramikchip auf die Diode D1 gestapelt ist, haben seine Kontaktanschlüsse gerade den geforderten Abstand vom Halbleiterbauelement, um die erfindungsgemässe Krümmung zu erzielen. Der Kontaktpfosten 13 von Fig. 2 kann somit entfallen.

Zusammenfassend kann festgehalten werden, dass die Erfindung schaltungstechnische und konstruktive Massnahmen vorgibt, mit welchen sich anwenderfreundliche Module zur Realisierung von Brückenschaltungen zusammensetzen lassen.

### Bezeichnungsliste

1 - Plus-Zuführung; 2 - Minus-Zuführung; 3 - Last; 4 - HS-Zweig; 5 - LS-Zweig; 6 - Lastanschluss; 7.1, 7.1 - Gate-Unit; 8 - Modulgehäuse; 9 - Keramiksubstrat; 10 - Kupferblock; 11 - Bandleiter; 12.1, 12.2 - Aetzgraben; 13 - Kontaktpfosten; 14 - Isolationsschicht; C - Clamping-Kondensator; Cg1, Cg2 - Kondensator; C1, C2 - Abblockkondensator; D1, D2 - Diode; F1, F2 - MOSFET; GU - Gateunit; L1 - Induktivität; L6 - Streuinduktivitäten; FCTh1, FCTh2 - abschaltbares Halbleiterbauelement; U_{DC} - Versorgungsgleichspannung; R - Dämpfungswiderstand.

## Patentansprüche

1. Leistungs-Halbleiterschaltung, umfassend
a) ein über ein Gate abschaltbares Halbleiterbauelement (FCTh1, FCTh2), und
b) eine Diode (D₁,D₂),
dadurch gekennzeichnet, dass
c) die Diode in Serie zum Halbleiterbauelement angeordnet ist, derart dass Diode und Halbleiterbauelement einen Viertelbrückenzweig bilden,
d) parallel zur Serieschaltung von Halbleiterbauelement und Diode ein niederinduktiver Abblockkondensator (C₁,C₂) zum Auffangen der Reverse Recovery Spannungsspitzen der Diode vorgesehen ist, und
f) Diode und Abblockkondensator niederinduktiv und räumlich unmittelbar neben dem Halbleiterbauelement angeordnet sind.

2. Leistungs-Halbleiterschaltung nach Anspruch 1, dadurch gekennzeichnet, dass der Abblockkondensator (C₁,C₂) ein niederinduktiver flacher Keramikchip ist, welcher auf oder neben der als flacher Halbleiterchip ausgebildeten Diode (D₁,D₂) angeordnet ist.

3. Leistungs-Halbleiterschaltung nach Anspruch 1, dadurch gekennzeichnet, dass die Kapazität des Abblockkondensators (C₁,C₂) so bemessen ist, dass eine Reverse Recovery Ladung der Diode (D₁,D₂) nur zu einer Spannungsänderung delta_U_{C} führen kann, die nicht mehr als 20 % einer Versorgungsgleichspannung U_{DC} beträgt.

4. Leistungs-Halbleiterschaltung nach Anspruch 1, dadurch gekennzeichnet, dass
a) Halbleiterbauelement (FCTh1,FCTh2), Diode (D₁,D₂) und Abblockkondensator (C₁,C₂) als Viertelbrückenzweig in einem Modulgehäuse (8) untergebracht sind,
b) zur Zuführung der Versorgungsgleichspannung (U_{DC}) zumindest zwei breite, niederinduktive Metallaschen als Plus- resp. Minus-Zuführung (1,2) vorgesehen sind und
c) ein nach aussen führender Lastanschluss zwischen Diode und Halbleiterbauelement angeschlossen ist, und
d) eine Ansteuerschaltung vorgesehen ist, welche an das Gate durch einen grossflächigen, niederinduktiven Bandleiter (11) angeschlossen ist und mindestens einen Stromimpuls zum Abschalten des Halbleiterbauelements erzeugt.

5. Leistungs-Halbleiterschaltung nach Anspruch 4, dadurch gekennzeichnet, dass
a) in einem Modulgehäuse (8) im Sinn eines Halbbrückenmoduls mindestens zwei Viertelbrückenzweige untergebracht sind, wobei
b) im einen Viertelbrückenzweig im Sinn eines HS-Zweiges das Halbleiterbauelement (FCTh1) mit seiner Anode an die Plus-Zuführung (1) und die Diode (D₁) zwischen Kathode des Halbleiterbauelements und Minus-Zuführung (2) geschlossen ist, und im zweiten im Sinn eines LS-Zweiges das Halbleiterbauelement (FCTh2) mit seiner Kathode an die Minus-Zuführung (2) und die Diode (D₂) zwischen Anode des Halbleiterbauelements und Plus-Zuführung (1) geschlossen ist, und
c) zum Verhindern der Folgen einer Durchzündung die Lastanschlüsse der Viertelbrückenzweige über eine Induktivität (L₁) verbunden sind.

6. Leistungs-Halbleiterschaltung nach Anspruch 5, dadurch gekennzeichnet, dass zwischen Plus- und Minuszuführung (1,2) zusätzlich ein separater Clamping-Kondensator (C) vorgesehen ist.

7. Leistungs-Halbleiterschaltung nach Anspruch 2 und 4, dadurch gekennzeichnet, dass das Halbleiterbauelement einerseits und Diode und Abblockkondensator andererseits auf einem isolierenden Keramiksubstrat (9) unmittelbar nebeneinander angeordnet sind.

8. Leistungs-Halbleiterschaltung nach Anspruch 7, dadurch gekennzeichnet, dass der Bandleiter (11) einen auf eine Hauptfläche des Halbleiterbauelements (FCTh1,FCTH2) aufgelöteten Abschnitt aufweist, und dass der Bandleiter unmittelbar ausserhalb des aufgelöteten Abschnitts derart von der Hauptfläche weggekrümmt ist, dass ein sich im Sperrzustand des Halbleiterbauelements aufbauendes elektrisches Feld am Rand der Hauptfläche nicht gestört wird.

9. Leistungs-Halbleiterschaltung nach Anspruch 1 und 6, dadurch gekennzeichnet, dass
a) das abschaltbare Halbleiterbauelement ein FCTh resp. ein komplementärer FCTh ist, welcher vorzugsweise in der Art eines Cu-Direct-Bondings auf dem Keramiksubstrat fixiert ist,
b) der Abblockkondensator (C₁,C₂) eine Kapazität zwischen 50 und 200 nF hat,
c) der zusätzliche Clamping-Kondensator (C) eine Kapazität zwischen 1 und 5 µF hat,
d) die Ansteuerschaltung mindestens einen MOSFET und mindestens einen Speicherkondensator umfasst, welche direkt auf den Bandleiter aufgelötet sind und
e) dass der Bandleiter (11) flexibel ist.

10. Leistungs-Halbleiterschaltung nach Anspruch 1, dadurch gekennzeichnet, dass
a) das abschaltbare Halbleiterbauelement ein IGBT ist, wobei
b) die Ansteuerschaltung den IGBT mit maximaler Geschwindigkeit ansteuert.

## Claims

1. Power semiconductor circuit, comprising
a) a gate-turn-off semiconductor component (FCTh1, FCTh2), and
b) a diode (D₁, D₂),
characterized in that
c) the diode is arranged in series with the semiconductor component in such a way that the diode and semiconductor component form a quarter-bridge arm,
d) a low-inductance blocking capacitor (C₁, C₂) is provided in parallel with the series circuit of semiconductor component and diode in order to absorb the reverse recovery voltage peaks of the diode, and
f) the diode and blocking capacitor are arranged with low inductance and spatially immediately adjacent to the semiconductor component.

2. Power semiconductor circuit according to Claim 1, characterized in that the blocking capacitor (C₁, C₂) is a low-inductance flat ceramic chip arranged on or near the diode (D₁, D₂), which is constructed as a flat semiconductor chip.

3. Power semiconductor circuit according to Claim 1, characterized in that the capacitance of the blocking capacitor (C₁, C₂) is dimensioned such that reverse recovery charging of the diode (D₁, D₂) can lead only to a voltage variation delta_U_{C} which is no greater than 20% of a d.c. supply voltage U_{DC}.

4. Power semiconductor circuit according to Claim 1, characterized in that
a) the semiconductor component (FCTh1, FCTh2), diode (D₁, D₂) and blocking capacitor (C₁, C₂) are accommodated as a quarter-bridge arm in a module case (8),
b) at least two wide, low-inductance metal lugs are provided as positive and negative lead (1, 2), respectively, for feeding the d.c. supply voltage (U_{DC}), and
c) a load terminal leading outwards is connected between the diode and semiconductor component, and
d) a drive circuit is provided which is connected to the gate by a large-area, low-inductance stripline (11) and generates at least one current pulse to turn off the semiconductor component.

5. Power semiconductor circuit according to Claim 4, characterized in that
a) at least two quarter-bridge arms are accommodated in a module case (8) as a half-bridge, it being the case that
b) the semiconductor component (FCTh1) is connected in one quarter-bridge arm as an HS arm with its anode to the positive lead (1) and the diode (D₁) between the cathode of the semiconductor component and negative lead (2), and the semiconductor component (FCTh2) is connected in the second arm as an LS arm with its cathode to the negative lead (2) and the diode (D₂) between the anode of the semiconductor component and positive lead (1), and that
c) to reduce the consequences of arc-through, the load terminals of the quarter-bridge arms are connected via an inductor (L₁).

6. Power semiconductor circuit according to Claim 5, characterized in that a separate clamping capacitor (C) is provided in addition between the positive and negative leads (1, 2).

7. Power semiconductor component according to Claims 2 and 4, characterized in that the semiconductor component, on the one hand, and diode and blocking capacitor, on the other hand, are arranged immediately mutually adjacent on an insulating ceramic substrate (9).

8. Power semiconductor circuit according to Claim 7, characterized in that the stripline (11) has a portion soldered onto a main surface of the semiconductor component (FCTh1, FCTh2), and in that the stripline is bent away from the main surface immediately outside the soldered-on portion in such a way that an electric field, which builds up at the edge of the main surface in the blocking state of the semiconductor component, is not disturbed.

9. Power semiconductor component according to Claims 1 and 6, characterized in that
a) the turn-off semiconductor component is an FCTh or a complementary FCTh, which is preferably fixed to the ceramic substrate in the form of a direct Cu bonding,
b) the blocking capacitor (C₁, C₂) has a capacitance of between 50 and 200 nF,
c) the additional clamping capacitor (C) has a capacitance of between 1 and 5 lF,
d) the drive circuit comprises at least one MOSFET and at least one storage capacitor, which are soldered directly onto the stripline, and
e) in that the stripline (11) is flexible.

10. Power semiconductor circuit according to Claim 1, characterized in that
a) the turn-off semiconductor component is an IGBT, it being the case that
b) the drive circuit drives the IGBT at the maximum rate.

## Revendications

1. Circuit semi-conducteur de puissance, comportant
a) un composant semi-conducteur (FCTh1, FCTh2) pouvant être éteint au moyen d'une grille, et
b) une diode (D1, D2),
caractérisé en ce que
c) la diode est disposée en série avec le composant semi-conducteur de sorte que la diode et le composant semi-conducteur forment une branche d'un quart-de-pont,
d) en parallèle sur le branchement en série du composant semi-conducteur et de la diode, un condensateur de découplage (C1, C2) à faible inductance est prévu pour amortir les pointes de tensions de reverse recovery de la diode, et
f) la diode et le condensateur de découplage sont disposés de manière à constituer une inductance faible et géométriquement immédiatement à côté du composant semi-conducteur.

2. Circuit semi-conducteur de puissance selon la revendication 1, caractérisé en ce que le condensateur de découplage (C1, C2) est un chip en céramique plat à faible inductance qui est disposé sur ou à côté de la diode (D1, D2) formée en chip semi-conducteur plat.

3. Circuit semi-conducteur de puissance selon la revendication 1, caractérisé en ce que la capacité du condensateur de découplage (C1, C2) est dimensionnée de telle sorte qu'une charge de reverse recovery de la diode (D1, D2) ne puisse entraîner qu'une variation de tension delta_U_{C} qui ne représente pas plus de 20 % d'une tension d'alimentation en courant continu U_{DC}.

4. Circuit semi-conducteur de puissance selon la revendication 1, caractérisé en ce que
a) le composant semi-conducteur (FCTh1, FCTh2), la diode (D1, D2) et le condensateur de découplage (C1, C2) sont montés en tant que branche d'un quart-de-pont dans un boîtier de module (8),
b) au moins deux larges languettes métalliques à faible inductance sont prévues comme amenées (1, 2) respectivement positive et négative pour amener la tension d'alimentation en courant continu (U_{DC}) et
c) un raccordement de la charge menant vers l'extérieur est raccordé entre la diode et le composant semi-conducteur, et
d) un circuit de commande est prévu qui est raccordé à la grille au moyen d'un conducteur en ruban (11) de grande surface et à faible inductance et qui génère au moins une impulsion de courant pour éteindre le composant semi-conducteur.

5. Circuit semi-conducteur de puissance selon la revendication 4, caractérisé en ce que
a) au moins deux branches d'un quart-de-pont sont montées dans un boîtier de module (8) dans l'esprit d'un module de demi-pont, où
b) dans une branche d'un quart-de-pont dans l'esprit d'une branche HS, le composant semi-conducteur (FCTh1) est raccordé par son anode à l'amenée positive (1) et la diode (D1) est raccordée entre la cathode du composant semi-conducteur et l'amenée négative (2), et dans l'autre branche dans l'esprit d'une branche LS, le composant semi-conducteur (FCTh2) est raccordé par sa cathode à l'amenée négative (2) et la diode (D2) est raccordée entre l'anode du composant semi-conducteur et l'amenée positive (1), et
c) les raccordements de puissance de la branche d'un quart-de-pont sont reliées au moyen d'une inductance (L1) pour éviter les conséquences d'un amorçage.

6. Circuit semi-conducteur de puissance selon la revendication 5, caractérisé en ce qu'un condensateur de clamping séparé (C) supplémentaire est prévu entre les amenées positive et négative (1, 2).

7. Circuit semi-conducteur de puissance selon les revendications 2 et 4, caractérisé en ce que le composant semi-conducteur d'une part et la diode et le condensateur de découplage d'autre part sont disposés immédiatement l'un à côté de l'autre sur un substrat en céramique isolant (9).

8. Circuit semi-conducteur de puissance selon la revendication 7, caractérisé en ce qu'un conducteur en ruban (11) présente une partie séparée soudée sur une surface principale du composant semi-conducteur (FCTh1, FCTh2) et se trouve coudé en s'écartant de la surface principale, immédiatement à l'extérieur de la partie séparée soudée, de telle sorte qu'un champ électrique qui se créé dans le composant semi-conducteur à l'état bloqué au bord de la surface principale ne soit pas perturbé.

9. Circuit semi-conducteur de puissance selon les revendications 1 et 6, caractérisé en ce que
a) le composant semi-conducteur à extinction est un FCTh respectivement un FCTh complémentaire, qui de préférence est fixé sur le substrat en céramique dans l'esprit d'un bonding direct Cu,
b) le condensateur de découplage (C1, C2) présente une capacité entre 50 et 200 nF,
c) le condensateur de clamping (C) supplémentaire présente une capacité entre 1 et 5 µF,
d) le circuit de commande comporte au moins un MOSFET et au moins un condensateur de stockage, qui sont soudés directement sur le conducteur en ruban et que
e) le conducteur en ruban (11) est flexible.

10. Circuit semi-conducteur de puissance selon la revendication 1, caractérisé en ce que
a) le composant semi-conducteur à extinction est un IGBT,
b) le circuit de commande assurant la commande de l'IGBT a la vitesse maximale.
